# EUROPÄISCHE PATENTANMELDUNG

(11) **EP 1 616 658 A1**
(43) Veröffentlichungstag der Anmeldung: **18.01.2006**
(21) Anmeldenummer: 05013544.1
(22) Anmeldetag: 23.06.2005
(51) Int. Cl.: B23K 35/26, B23K 35/14

(54) **Bleifreie Lotpasten mit erhöhter Zuverlässigkeit**

(30) Priorität: 13.07.2004 DE 102004034035
(71) Anmelder: W.C. Heraeus GmbH, 63450 Hanau (DE)
(72) Erfinder: Brand, Alexander, 63820 Elsenfeld (DE); Grebner, Steffen, 63776 Mömbris (DE); Schmitt, Wolfgang, 63110 Rodgau (DE); Trodler, Jörg, 63526 Erlensee (DE)
(74) Vertreter: Kühn, Hans-Christian

(57) **Zusammenfassung**

Erfindungsgemäß wird das Einschleppen unerwünschter intermetallischer Phasen (IMP) reduziert. Hierzu werden Lotpasten bereitgestellt, die eine Metallpulvermischung aufweisen, die einen Schmelzbereich von mindestens 5 Kelvin und vorzugsweise weniger als 30 Kelvin erzeugen. Geeignet hierfür ist eine Metallpulvermischung bei der die Schmelzpunkte der Metallpulverkomponenten über 5 Kelvin, insbesondere über 10 Kelvin, vorzugsweise über 15 K auseinander liegen und ggf. unter 30 Kelvin insbesondere bis 25 Kelvin. Es sind aber auch Metallpulvermischungen möglich, bei denen die Schmelzpunkte 100 Kelvin und mehr betragen können, wenn sich die höherschmelzende Komponente unterhalb ihres Schmelzpunktes in der Schmelze löst, so dass der Schmelzbereich unter 30 Kelvin gehalten werden kann. Mit den erfindungsgemäßen Lotpasten können unerwünschte intermetallische Phasen fast beliebig gering gehalten werden.

## Beschreibung

Die vorliegende Erfindung betrifft Lotpasten, insbesondere bleifreie Lotpasten auf Basis von SAC.

Lotpasten wie beispielsweise SnAg4Cu0,5 neigen zur Voidsbildung und damit gegenüber bleihaltigen Loten zu verminderter Stabilität und damit verminderter Zuverlässigkeit der Lötstellen.

Gemäß US 5,527,628 werden in einer Legierung neben einer eutektischen Zusammensetzung Sn93,6Ag4,7Cu1,7 weitere nichteutektische Zusammensetzungen dieses Dreistoffsystems Zinn-Silber-Kupfer (SAC) oder Zusammensetzungen aus Zweistoffsystemen Zinn-Silber und Zinn-Kupfer eingebracht, um einen Schmelzbereich für das Weichlot zu erzeugen. Solche technischen Lotzusammensetzungen, insbesondere SAC-Lote weisen intermetallische Phasen (IMP) auf. IMP mit stöchiometrischer Zusammensetzung (z.B. Cu3Sn, Cu6Sn5) haben im Allgemeinen eine geringe Kristallsymmetrie und sind meist sehr spröde. Verbindungen die über einen größeren Bereich stabil sind (z.B. Ag3Sn), haben zwar im Allgemeinen eine höhere Symmetrie und sind meist auch duktiler, können aber dennoch die Stabilität eines Lötgefüges reduzieren. Somit bestehen unerwünschte IMP in Weichloten, die mehrere Zusammensetzungen aufweisen. Diese sogenannten kritischen intermetallischen Phasen sind deshalb unerwünscht, weil sie beim Lötvorgang erhalten bleiben, dabei anwachsen und deshalb dem finalen Lotgefüge Sprödigkeit und Sollbruchstellen verleihen, die dessen mechanische Stabilität beeinträchtigt. Intermetallische Phasen bilden sich zwar auch beim Löten an der Kontaktfläche aber es werden weitere intermetallische Phasen durch das Lot hineingeschleppt, die im Lot sowieso vorhanden sind, die sich wiederum beim Lötprozess vergrößern und im Laufe der Zeit weiter vergrößern und deshalb zum Korngrenzenbruch bzw. Kornzerfall führen.
Die Aufgabe der vorliegenden Erfindung ist es, die Qualität von Lotpasten weiter zu verbessern, insbesondere die Neigung zur Voidbildung zu reduzieren.

Zur Lösung der Aufgabe wird das Einschleppen unerwünschter intermetallischer Phasen (IMP) reduziert. Hierzu werden Lotpasten bereitgestellt, die eine Metallpulvermischung aufweisen, die einen Schmelzbereich von mindestens 5 Kelvin und vorzugsweise weniger als 30 Kelvin erzeugen. Geeignet hierfür ist eine Metallpulvermischung bei der die Schmelzpunkte der Metallpulverkomponenten über 5 Kelvin, insbesondere über 10 Kelvin, vorzugsweise über 15 K auseinander liegen und ggf. unter 30 Kelvin insbesondere bis 25 Kelvin. Es sind aber auch Metallpulvermischungen möglich, bei denen die Schmelzpunkte 100 Kelvin und mehr betragen können, wenn sich die höherschmelzende Komponente unterhalb ihres Schmelzpunktes in der Schmelze löst, so dass der Schmelzbereich unter 30 Kelvin gehalten werden kann. Mit den erfindungsgemäßen Lotpasten können unerwünschte intermetallische Phasen fast beliebig gering gehalten werden. Außerdem lässt sich die Voidsbildung gemäß dem Voidtest erheblich reduzieren. Insbesondere kann die Voidbildung von Zinn-, Silber-, Kupfer- (SAC)-Legierungen um bis zu einer Größenordnung gesenkt werden. Diese Pasten ermöglichen somit stabilere und deshalb wiederum zuverlässigere Lotgefüge, die für die Elektronikmontage von größtem Interesse sind. Besonders wichtige Anwendungen ergeben sich für den Leiterplattenbau und das Waverbumping. Die finale Legierung des Lotgefüges entsteht zumindest teilweise erst beim Löten. Deshalb werden mit der Pulvermischung weniger kritische intermetallische Phasen (IMP) in den Lötvorgang eingebracht. Würden mit einer finalen Legierung (Ziellegierung) 100 % IMP dem Lötvorgang zugeführt, so werden von der Pulvermischung IMP entsprechend dem Anteil reduziert der sich erst beim Löten als finale Legierung bildet.

In bevorzugten Ausführungen
- ist die Pulvermischung in einem Temperaturbereich schmelzbar, der die Temperatur eines Eutektikum dieses Systems um weniger als 30 Kelvin überschreitet;
- entspricht die Summe der Metallpulver einem ternären, quartärem oder höherem Metallsystem;
- unterscheiden sich die Metallpulver hinsichtlich ihrer Teilchengrößenverteilung, wobei besonders bevorzugt das feinste Pulver den höchsten Schmelzpunkt aufweist oder den geringsten Massenanteil hat;
- weist die bleifreie Lotpaste Pulver unterschiedlicher Metallzusammensetzung auf, wobei wenigstens zwei Metallpulver hinsichtlich eines Legierungsbestandsteils neben der Hauptkomponente so beschaffen sind, dass ein Pulver davon einen erhöhten Gehalt aufweist und das andere Metallpulver weniger bis nichts davon enthält;
- ist die Lotpaste eine Zinn-Silber-Kupfer-Lotpaste;
- ist die Hauptkomponente eine SAC-Legierung, insbesondere mit einem Legierungsanteil von 2 bis 5 % Silber und 0,2 bis 1 % Kupfer, vorzugsweise 3 bis 4 % Silber und 0,3 bis 0,8 % Kupfer;
- weist die SAC-Pulvermischung in der Summe 2 bis 5 Gew.-% Silber und 0,2 bis 1 Gew.-% Kupfer auf, vorzugsweise 3 bis 4 Gew.-% Silber und 0,4 bis 0,8 Gew.-% Kupfer.

Zur Herstellung solcher Pasten werden mindestens zwei Metallpulver unterschiedlichen Schmelzpunktes mit einem Flussmittel vermischt. Hierzu eignen sich die bekannten Herstellungsverfahren wie z.B. zum Anteigen, Rühren, Kneten und Homogenisieren von Pasten.

Erfindungsgemäß lässt sich ein Lötprozess, bei dem ein Metallpulver zu einem Lotgefüge umgeschmolzen wird, unter Reduzierung unerwünschter IMP gestalten. Maßgeblich hierfür ist der Auftrag mit einer Paste, die Pulver mit unterschiedlichem Legierungszusammensetzungen ggf auch Reinmetall aufweist, die wiederum im allgemeinen einen unterschiedlichen Schmelzbereich oder Schmelzpunkt aufweisen. Die Zusammensetzung des Lötgefüges wird dabei durch die Mischungsverhältnisse der Metallpulver vorbestimmt, aber erst beim Lötvorgang, d.h. beim Schmelzen der Paste, realisiert. Dabei lassen sich IMP hinsichtlich Qualität und Quantität weitgehend einstellen.

Weiterhin wird es ermöglicht, technische Standardlegierungen als Metallpulvermischungen so zu kombinieren, dass die Zusammensetzung der Lotpaste einer individuellen Ziellegierung entspricht.

Vorzugsweise enthalten die Lotpasten der vorliegenden Erfindung als Hauptkomponente eines der Elemente Zinn, Kupfer, Silber, Gold oder Platin. Die weiteren Komponenten sind so ausgewählt, dass die Pulverzusammensetzung einen Schmelzbereich in der Nähe eines Eutektikums erzeugt. Die in der Lotpaste gemischten Metallpulver weisen neben unterschiedlicher Zusammensetzung vorzugsweise auch unterschiedliche Teilchengrößen auf. Dabei hat sich bewährt, wenn das Pulver mit der am niedrigsten schmelzenden Zusammensetzung, beispielsweise einer eutektischen Zusammensetzung der Hauptbestandteil der metallischen Pulver ist und bevorzugt die durchschnittlich größten Pulverteilchen aufweist. Die Teilchengrößen sollten sich wenigstens um den Faktor 0,7 unterscheiden, vorzugsweise bis zu einer Größenordnung, wobei jedoch auch zwei Größenordnungen vorteilhaft sein können, insbesondere wenn es sich um eine relativ hoch schmelzende Legierung handelt und ganz besonders dann, wenn die hochschmelzende Legierung von der Schmelze aufgelöst werden muss. Der Schmelzbereich muss daher nicht unbedingt mit dem Schmelzbereich eines Phasendiagramms übereinstimmen. Wesentlich für den Schmelzbereich ist, dass die Metallpulver in diesem Bereich eine Schmelze bilden und alle Pulver zumindest zu einem wesentlichen Anteil innerhalb eines Schmelzbereichs von unter 30 Kelvin, insbesondere bis 25 Kelvin schmelzen oder sich in der Schmelze lösen. Hinsichtlich des Schmelzbereichs kann sich sowohl der untere wie auch der obere Schmelzbereichsgrenzwert von dem jeweils unteren oder oberen Wert einer anderen Legierung oder dem Schmelzpunkt eines reinen Metalls unterscheiden. Die einzelnen Metallpulver können Reinmetalle oder Legierungen sein, müssen aber als Pulvermischung in der Lage sein, innerhalb eines Schmelzbereichs von weniger von 30 Kelvin, insbesondere maximal 25 Kelvin eine Legierung auszubilden, vorzugsweise eine ternäre oder höhere Legierung. Die Pulver müssen also in der Lage sein, eine Schmelze zu bilden, die mindestens zwei Elemente enthält, vorzugsweise mindestens drei.

Mit den bleifreien Pasten soll die neue Gesetzeslage vieler Länder berücksichtigt werden. Als Grenzwert für den Bleigehalt ist 1 ‰ vorgesehen (Elektronik Praxis Marktreport Bleifrei - Juni 2004, Seite 6).
Durch die Pulverzusammensetzungen lässt sich der Anteil an kritischen intermetallischen Phasen (IMP) um über eine Größenordnung reduzieren. Damit verbunden ist eine bedeutend erhöhte Stabilität des Lötgefüges.

Im folgenden wird die Erfindung mit Bezug auf die Abbildungen anhand von Beispielen verdeutlicht.
Fig.1a und 1b zeigen die IMP in Schliffbildern von SnAg4Cu0,5.

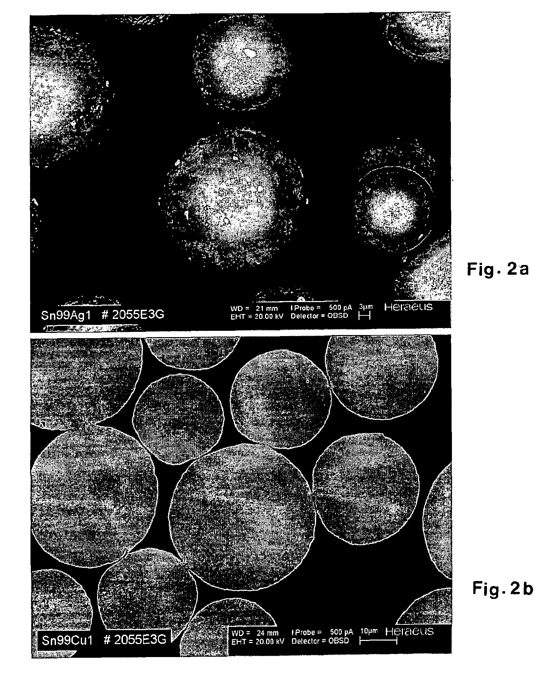

Fig. 2a zeigt Sn99Ag1 in Schliffbildern. Es sind kaum IMP erkennbar.
Fig. 2b zeigt Sn99Cu1 in Schliffbildern. Es sind kaum IMP erkennbar.

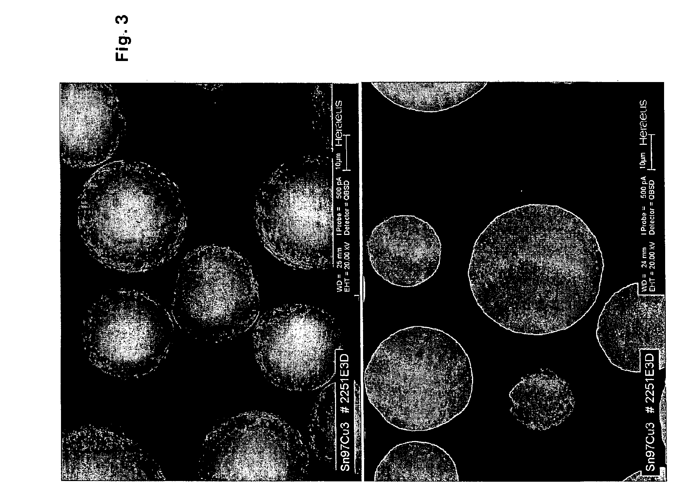

Fig. 3 zeigt die geringen IMP von Sn97Cu3 in Schliffbildern.

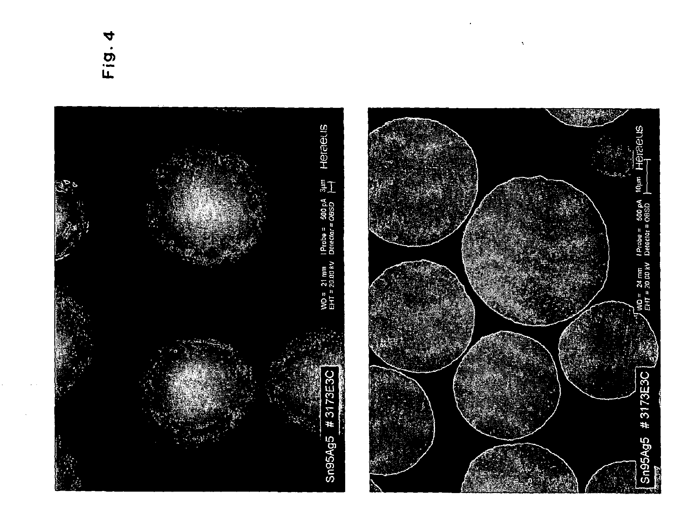

Fig. 4 zeigt Sn95Ag5 in Schliffbildern Es sind keine IMP erkennbar.

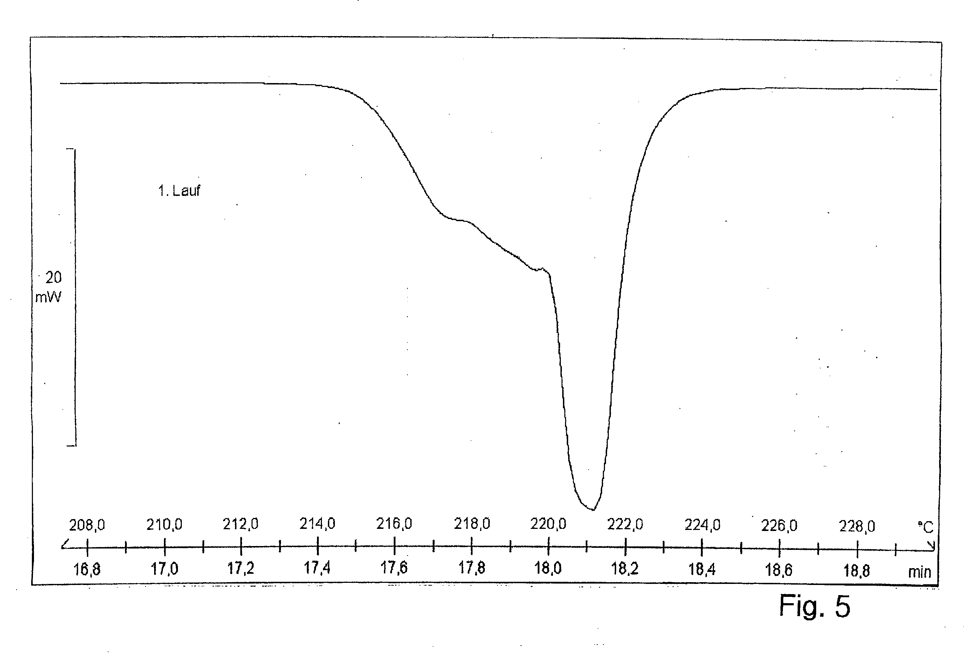

Fig. 5 zeigt den Schmelzbereich der Pulvermischung von Bsp.1

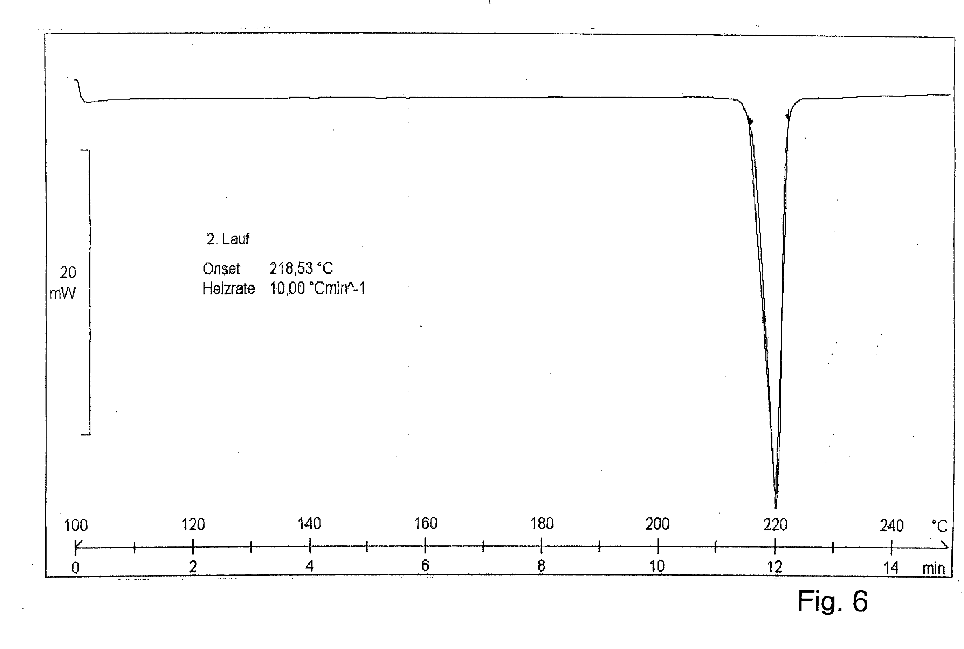

Fig. 6 zeigt den Schmelzpunkt der aus der Pulvermischung von Bsp. 1 entstandenen Legierung
Fig. 7 a zeigt in der linken Seite den Anteil kleiner Voids und auf der rechten Seite den Anteil großer Voids.
Fig. 7b zeigt eine Qualitätsbewertung

### Beispiele

Lotpasten mit den Ziellegierungen SnAg4Cu0,5 und Sn96,5Ag3Cu0,5 wurden mit dem Unterschied, dass hier verschiedene Legierungen zu einer Pulvermischung gemischt werden, nach einem üblichen Herstellungsverfahren für Lotpasten hergestellt. Die Pulver entsprechen der Pulverkorngröße 3 gemäß EN 61190-1-2:2002. Deutlich erkennbare IMP waren lediglich im SnAg4Cu0,5 Pulver und Sn96,5Ag3Cu0,5 Vergleichspulver festzustellen.

SnAg4Cu0,5 (Schmelzpunkt 217°C),
Sn96Ag4 (Schmelz 222°C)
Sn99 Cu1 (Schmelzpunkt ungefähr 227°C).
Sn95Ag5 (Schmelzbereich 221 bis 240°C)
Sn99,15Cu0,85 (Schmelzpunkt ungefähr 229°C
Ziellegierung **SnAg4Cu0,5**
Bsp. 1
   80 % SnAg4Cu0,5 und 16 % Sn95Ag5und 3 %Sn97Cu3 und 1 %Sn99Cu1
Bsp. 2
   60 % SnAg4Cu0,5 und 32 % Sn95Ag5und 6 %Sn97Cu3 und 2 %Sn99Cu1
Bsp.3
   50 % SnAg4Cu0,5 und 15 % Sn100 und 10 %Sn80Cu20 und 25 %Sn99Cu1
   Ziellegierung **Sn96,5Ag3Cu0,5**
Bsp. 4
   50 Gew.-% SnAg4Cu0,5, 25 Gew.-% Sn96Ag4 und 25 Gew.-% Sn99 Cu1
Bsp. 5
   50 Gew.-% SnAg4Cu0,5, 20 Gew.-% Sn95Ag5 und 30 Gew.-% Sn99, 15Cu0,85.
Bsp. 6
   50 Gew.-% Sn95,5Ag4Cu0,5 und 20 Gew.-% Sn95Ag5 und 30 Gew.-% Sn99,15Cu0,85

Die Lotpasten werden jeweils auf einen Kupferpunkt einer Platine gelötet und die Lötstelle beurteilt.
Die aus den erfindungsgemäßen Pulvern hergestellten Lötstellen enthalten deutlich weniger IMP als die aus den Legierungen SnAg4Cu0,5 (Vgl. 1) und Sn96,5Ag3Cu0,5 (Vgl. 2) hergestellten. Die Mischung mit 80 % SnAg4Cu0,5 lag ungefähr zwischen den Vergleichsbeispielen und den weiteren erfindungsgemäßen Beispielen die nur noch ungefähr halb soviel IMP aufweisen wie die Vergleichsbeispiele.

Die mechanische Belastbarkeit hinsichtlich Schlagempfindlichkeit und Vibration ist bei den erfindungsgemäß hergestellten Lötstellen verbessert, ebenso die Temperaturwechselbeständigkeit.

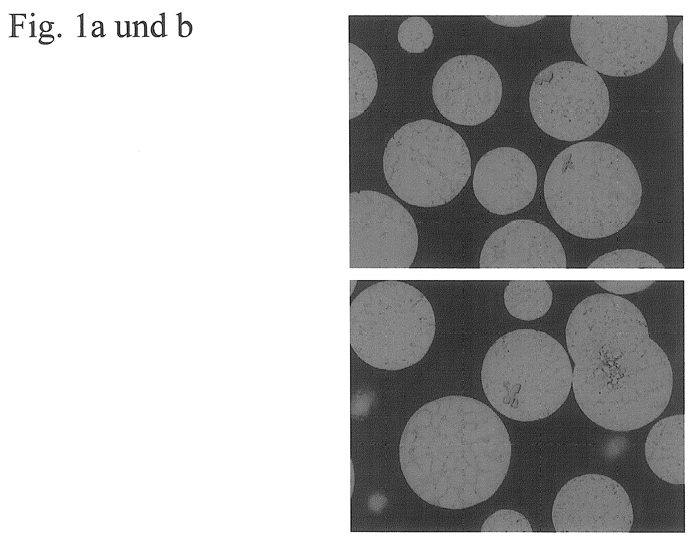

Der Schmelzbereich von Bsp. 1 wurde gemäß Fig. 1 mittels Differential-Thermo-Analyse (DTA) bestimmt. Die nachfolgende DTA zeigt anhand des scharfen Schmelzpunktes, das die aus der Pulvermischung entstandene Legierung nahezu eutektisch ist.

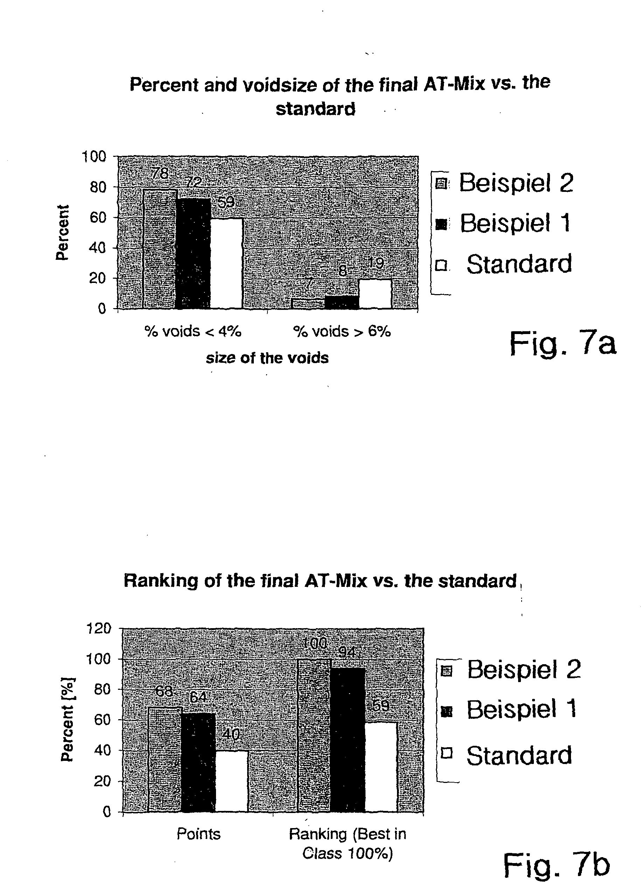

Nach dem Voidtest entsprechend dem Artikel "Avoiding the Solder Void", von Richard Lathrop, Heraeus Circuit Materials Division, Philadelphia, Pennsylvania, sind die erfindungsgemäßen Pasten gegenüber den Legierungen verbessert. In Fig. 7a werden die gemessenen Voids dargestellt. Erfindungsgemäß konnten die großen Voids stark reduziert werden. Hieraus folgt eine Qualitätsbewertung nach Fig. 7b bei der die erfindungsgemäßen Zusammensetzungen gemäß Bsp. 1 und 2 mit 68 und 64 Punkten einen deutlichen Qualitätszuwachs gegenüber dem Standart (Vgl. 1) erzielen.

## Patentansprüche

1. Bleifreie Lotpaste **dadurch gekennzeichnet, dass** die Lotpaste mindestens zwei Metallpulver aufweist, deren Schmelzpunkte oder Schmelzbereich mindestens 5 Kelvin auseinanderliegen, insbesondere mindestens 10 Kelvin.

2. Bleifreie Lotpaste nach Anspruch 1, **dadurch gekennzeichnet, dass** die Summe der Metallpulver mindestens ein ternäres Metallsystem ist.

3. Bleifreie Lotpaste nach Anspruch 2, **dadurch gekennzeichnet, dass** die Lotpaste eine Zinn-Silber-Kupfer Lotpaste ist.

4. Zinn-Silber-Kupfer Lotpaste nach Anspruch 3 **dadurch gekennzeichnet, dass** die Pulvermischung in der Summe 2 bis 5 % Silber und 0,1 bis 1 % Kupfer aufweist, insbesondere 3 bis 4 % Silber und 0,3 bis 0,8 % Kupfer.

5. Bleifreie Lotpaste nach einem der Ansprüche 1 bis 5, **dadurch gekennzeichnet, dass** die Schmelzpunkte oder Schmelzbereiche weniger als 30 Kelvin auseinanderliegen, insbesondere maximal 25 Kelvin.

6. Verfahren zur Herstellung stabiler Lotgefüge, **dadurch gekennzeichnet, dass** das Einschleppen von intermetallischen Phasen in das Lotgefüge **dadurch** verringert wird, dass die finale Legierung erst beim Lötvorgang erzeugt wird und zum Legieren vorgesehene Bestandteile weniger intermetallische Phasen enthalten als eine dem finalen Lötgefüge entsprechende Legierungszusammensetzung.

7. Verfahren zur Reduzierung intermetallischer Phasen in einem Lötgefüge, bei dem Metallpulver zu einem Lötgefüge umgeschmolzen wird,
**dadurch gekennzeichnet**, das Metallpulver eine Mischung aus mindestens zwei Pulvern mit einem um mindestens 5 K unterschiedlichen Schmelzpunkt oder Schmelzbereich ist.

8. Verfahren zur Herstellung einer Lotpaste, **dadurch gekennzeichnet, dass** mindestens zwei Metallpulver mit einem um mindestens 5 K unterschiedlichen Schmelzpunkt oder Schmelzbereich mit einem Flussmittel zu einer Paste gefertigt werden.

9. Verwendung einer mindestens zwei unterschiedliche Metallpulver aufweisenden, bleifreien Lotpaste zum Waferbumbing oder Leiterplattenmontage.
